# FASCICULE DE BREVET EUROPEEN

(11) **EP 3 049 461 B1**
(45) Date de publication et mention de la délivrance du brevet: **21.11.2018**
(21) Numéro de dépôt: 14784502.8
(22) Date de dépôt: 17.09.2014
(51) Int. Cl.: C08G 81/02, C08J 5/18, C08L 87/00, H01L 31/048

(54) **COMPOSITION THERMOPLASTIQUE, NOTAMMENT POUR LES MODULES PHOTOVOLTAÏQUES**
THERMOPLASTISCHE ZUSAMMENSETZUNG, INSBESONDERE FÜR FOTOVOLTAIKMODULE
THERMOPLASTIC COMPOSITION, IN PARTICULAR FOR PHOTOVOLTAIC MODULES

(30) Priorité: 24.09.2013 FR 1359174
(43) Date de publication de la demande: 03.08.2016
(73) Titulaire: Arkema France, 92700 Colombes (FR)
(72) Inventeur: AUSSEDAT, Grégoire, 75009 Paris (FR); JOUSSET, Dominique, F-78380 Bougival (FR); BIZET, Stéphane, F-27170 Barc (FR); FLAT, Jean-Jacques, F-27170 Goupillieres (FR); DEVISME, Samuel, 76000 Rouen (FR)
(74) Mandataire: Kling, Simone
(86) Numéro de dépôt international: PCT/FR2014/052313
(87) Numéro de publication internationale: WO 2015/044560

(56) Documents cités:
- EP-A2- 1 342 764
- WO-A1-2009/138679
- WO-A1-2012/085369
- WO-A1-2012/107654

## Description

### Domaine de l'invention

L'invention a pour objet une composition thermoplastique comprenant au moins une première polyoléfine particulière associée à une deuxième polyoléfine greffée polyamide dont les greffons présentent une température de transition vitreuse, ou de fusion, inférieure à 160°C. La présente invention concerne également l'utilisation de cette composition dans un module photovoltaïque, plus précisément dans une ou plusieurs des couches formant un tel module, plus particulièrement dans la couche formant encapsulant.

Le réchauffement climatique, lié aux gaz à effet de serre dégagés par les énergies fossiles, a mené au développement de solutions énergétiques alternatives qui n'émettent pas de tels gaz lors de leur fonctionnement, comme par exemple les modules photovoltaïques. Un module photovoltaïque comprend une « pile photovoltaïque », cette pile étant capable de transformer l'énergie lumineuse en électricité.

Il existe de nombreux types de structures de panneaux photovoltaïques.

La structure d'un module photovoltaïque comprend classiquement trois couches, une couche centrale logeant les cellules photovoltaïques présentant des propriétés photoélectriques, entourée de part et d'autre d'une couche de protection.

La couche centrale est dénommée classiquement encapsulant tandis que les couches de protection sont appelées « frontsheet », couche transparente destinée à autoriser le passage des rayons solaires, et « backsheet », couche devant être la plus étanche/hermétique possible.

En présence de rayonnement solaire, il se crée un échauffement à l'intérieur du module solaire et des températures de 80°C (ou plus) peuvent être atteintes ce qui nécessite que les couches soient parfaitement liées les unes aux autres tout au long du cycle de vie du module.

De manière générale, les modules photovoltaïques étant placés à l'extérieur et dans des environnements extrêmes, ils subissent des contraintes et des agressions constantes. Enfin, les propriétés des matériaux thermoplastiques utilisés doivent permettre de garantir une conservation à long terme des propriétés photoélectriques du module, autrement dit sans subir de dégradations notables.

Au titre des propriétés physico-chimique de ces matériaux thermoplastiques, on peut citer notamment une excellente tenue au fluage à 100°C ou plus, de bonnes propriétés optiques, de bonnes propriétés de durabilité en chaleur humide et sous UV (Ultra Violet), de bonnes propriétés électriques, une faible reprise en humidité et d'excellentes propriétés barrières.

### Etat de l'art

A l'heure actuelle, on connaît dans le domaine des modules photovoltaïques des compositions réticulables consistant en des polyoléfines, en particulier de type EVA (Ethylène - Acétate de Vinyle), pour former l'encapsulant. Or, des problèmes de durabilité des modules photovoltaïques sont rencontrés avec ce type d'encapsulant notamment liés au relargage d'acide acétique en chaleur humide (85°C / 85 % HR : « Humidity Rate ») qui accélère la corrosion des cellules. Il est également connu que des modules photovoltaïques fabriqués avec ces copolymères éthylène - acétate de vinyle comme encapsulant sont particulièrement sensibles au problème de dégradation induite sous différence de potentiel mieux connu sous l'abréviation anglaise PID pour « Potential Induced Dégradation ». Il est également connu des encapsulants thermoplastiques de type polyoléfine. Le problème de ces thermoplastiques est qu'ils ne tiennent pas en fluage, ce qui les rend impropres pour une telle application.

On connaît par ailleurs une composition polyoléfine greffée polyamide (greffons de polyamide fixés sur la chaine principale). De telles compositions sont décrites dans les documents de la demanderesse FR 2918150 ou EP 2196489. Il a même déjà été envisagé de mélanger de telles polyoléfines greffées polyamide avec une polyoléfine, notamment dans le document WO 0228959 au nom de la demanderesse.

Néanmoins, de tels mélanges peuvent présenter un défaut majeur pour l'application photovoltaïque. En effet, ces mélanges engendrent un taux d'humidité élevé (reprise d'eau importante) ce qui limite la durabilité des modules photovoltaïques (chute du rendement) après un certain temps d'utilisation ou lors de tests en chaleur humides sous polarisation.

### Brève description de l'invention

Il a été constaté par la demanderesse, après diverses expériences et manipulations, que, contrairement aux enseignements bien connus de l'homme du métier, un choix particulier de greffons polyamide (pour la polyoléfine greffée polyamide), présents en poids de la composition dans un taux bien spécifique, combiné à celui de deux polyoléfines spécifiques, dans des taux appropriés, permet de résoudre les problèmes liés aux compositions de l'art antérieur, en particulier celle divulguée dans le document WO 0228959.

Ainsi, la composition selon la présente invention, tout en conservant des propriétés mécanique, thermomécanique, optique, électrique, tout à fait satisfaisantes, comble les dernières lacunes que peuvent présenter ces matériaux thermoplastiques par ailleurs extrêmement performants, à savoir que cette composition présente une reprise à l'eau faible, voire très faible, et une dégradation dans le temps (chute de résistivité électrique) particulièrement améliorée.

Ainsi, la présente invention concerne une composition thermoplastique comprenant au moins un mélange de trois polymères, dans laquelle :
- le premier polymère, présent dans la composition entre 10% et 70% en poids, consiste en un polymère greffé polyamide présentant un tronc en polyoléfine contenant un reste d'au moins un monomère insaturé (X) et une pluralité de greffons en polyamide, dans lequel :
   - les greffons en polyamide sont attachés au tronc en polyoléfine par le reste du monomère insaturé (X) comprenant une fonction capable de réagir par une réaction de condensation avec un polyamide ayant au moins une extrémité amine et/ou au moins une extrémité acide carboxylique,
   - le reste du monomère insaturé (X) est fixé sur le tronc par greffage ou copolymérisation,
   - les greffons en polyamide représentent de 10% à 60%, de préférence de 15% à 55%, en poids dudit polymère greffé polyamide,
- le second polymère, présent dans la composition à hauteur d'au moins 10 % en poids, consiste en un copolymère d'éthylène et d'un comonomère non réactif ou non fonctionnalisé dont le module élastique en flexion est inférieur à 250 Mpa à 23°C et qui présente un point de fusion cristalline compris entre 60°C et 120°C,
- le troisième polymère, présent dans la composition entre 3 % et 45 % en poids de ladite composition, consistant en une polyoléfine fonctionnalisée comprenant un copolymère d'au moins une alpha-oléfine, telle que l'éthylène ou le propylène, avec au moins un comonomère portant une fonction réactive, et au moins un autre comonomère ne portant pas de fonction réactive, choisi parmi une alpha-oléfine différente de la susdite alpha-oléfine, un diène, un ester d'acide carboxylique insaturé, et un ester vinylique d'acide carboxylique,
caractérisée en ce que les greffons en polyamide du susdit premier polymère présentent une température de transition vitreuse ainsi qu'une température de fusion inférieures ou égale à 160°C,
et en ce que le taux des greffons polyamide dudit premier polymère représente de 3 % à 15 %, de préférence entre 5 % et 12,5 %, en poids de la composition thermoplastique.

Selon une possibilité offerte par l'invention, le second polymère consistera en un copolymère de l'éthylène et d'un (méth)acrylate d'alkyle.

De préférence, le troisième polymère consiste en un copolymère éthylène - ester acrylique - méthacrylate de glycidyle ou éthylène - ester acrylique - anhydride maléique.

Avantageusement, le troisième polymère est présent entre 10% et 30%, en poids de la composition.

D'autres caractéristiques avantageuses de l'invention sont précisées dans la suite :
Avantageusement, la masse molaire en nombre des susdits greffons polyamide du susdit polymère greffé est comprise dans la gamme allant de 1000 à 10000 g/mol.

Selon une particularité de l'invention, pour les susdits polymères greffés, le nombre de monomère (X) fixé sur le tronc en polyoléfine est supérieur ou égal à 1,3 et/ou inférieur ou égal à 20.

Selon un aspect de l'invention, le susdit premier polymère est présent entre 10% et 50% en poids de la composition.

De préférence, les greffons polyamide du première polymère consistent en des copolyamides choisi parmi les copolyamides PA 6/11, PA6/12 et PA6/11/12.

De préférence, le monomère insaturé (X) du premier polymère est un anhydride maléique.

De préférence, le second polymère est présent dans la composition entre dans la composition entre 40% et 70% en poids.

Selon une possibilité offerte par l'invention, la composition selon l'invention consiste uniquement en les trois susdits polymères.

L'invention se rapporte également à un film comprenant la composition selon l'invention telle que décrite ci-dessus.

L'invention concerne également un film thermoplastique d'un module photovoltaïque, ledit module photovoltaïque comprenant au moins deux couches dont l'une forme la couche d'encapsulant, caractérisé en ce que la couche d'encapsulant comprend, de préférence consiste en, la composition thermoplastique telle que décrite précédemment.

De préférence, la couche formant encapsulant comprend des promoteurs d'adhésion consistant en un ingrédient non polymérique, de nature organique, cristalline ou minéral et plus préférentiellement semi-minéral semi-organique des antioxydants et/ou des agents anti-UVs.

Il doit être noté que la composition selon l'invention est présentée avec pour application un module photovoltaïque, plus particulièrement sa couche d'encapsulant, mais bien entendu cette composition pourra être envisagée pour toutes autres applications où une telle composition est avantageusement utilisable, notamment dans les structures multicouches telles que par exemple des chaussures, les films ou revêtements adhésifs, ou les tubes de transport de fluides.

La description qui va suivre est donnée uniquement à titre illustratif et non limitatif.

### Description détaillée de l'invention

S'agissant du premier polymère susmentionné, il s'agit donc d'un polymère greffé, avec entre 10% et 70%, de préférence entre 15% et 55%, en masse de greffons polyamide et un nombre de monomères (X) compris entre 1,3 et 20.

S'agissant du tronc polyoléfine, c'est un polymère comprenant comme monomère une α-oléfme.

On préfère les α-oléfines ayant de 2 à 30 atomes de carbone.

A titre d'a-oléfine, on peut citer l'éthylène, le propylène, 1-butène, 1-pentène, 3-méthyl-1-butène, 1-hexène, 4-méthyl-1-pentène, 3-méthyl-1-pentène, 1-octène, 1-décène, 1-dodécène, 1-tétradécène, 1-hexadécène, 1-octadécène, 1-eicocène, 1-dococène, 1-tétracocène, 1-hexacocène, 1-octacocène, et 1-triacontène.

On peut également citer les cyclo-oléfines ayant de 3 à 30 atomes de carbone, préférentiellement de 3 à 20 atomes de carbone, tels que le cyclopentane, le cycloheptène, le norbornène, le 5-méthyl-2-norbomène, le tétracyclododécène, et le 2-méthyl-1,4,5,8-diméthano-1,2,3,4,4a,5,8,8a-octahydronaphthalène ; di et polyoléfines, telles que la butadiène, l'isoprène, le 4-méthyl-1,3-pentadiène, le 1,4-pentadiène, 1,5-hexadiène, 1,3-hexadiène, 1,3-octadiène, 1,4-octadiène, 1,5-octadiène, 1,6-octadiène, l'éthylidènenorbomène, le vinyle norbornène, le dicyclopentadiène, le 7-méthyl-1,6-octadiène, le 4-éthylidiène-8-méthyl-1,7-nonadiène, et le 5,9-diméthyl-1,4,8-décatriène ; les composés vinyliques aromatiques tels que le mono- ou poly alkylstyrènes (comprenant le styrène, o-méthylstyrène, m-méthylstyrène, p-méthylstyrène, o,p-diméthylstyrène, o-éthylstyrène, m-éthylstyrène et p-éthylstyrène), et les dérivés comprenant des groupes fonctionnels tels que le méthoxystyrène, l'éthoxystyrène, l'acide benzoïque vinylique, le benzoate de méthyle vinyle, l'acétate de benzyle vinyle, l'hydroxystyrène, l'o-chlorostyrène, le p-chlorostyrène, le di-vinyle benzène, le 3-phénylpropène, le 4-phénylpropène, le α-méthylstyrène, le vinyle chloride, le 1,2-difluoroéthylène, le 1,2-dichloroéthylène, le tétrafluoroéthylène, et le 3,3,3-trifluoro-1-propène.

Dans le cadre de la présente invention, le terme d'a-oléfine comprend également le styrène. On préfère le propylène et tout spécialement l'éthylène comme α-oléfine.

Cette polyoléfine peut-être un homopolymère lorsqu'une seule α-oléfine est polymérisée dans la chaîne polymère. On peut citer comme exemples le polyéthylène (PE) ou le polypropylène (PP).

Cette polyoléfine peut aussi être un copolymère lorsqu'au moins deux comonomères sont copolymérisés dans la chaîne polymère, l'un des deux comonomères dit le « premier comonomère » étant une α-oléfine et l'autre comonomère, dit « deuxième comonomère », est un monomère capable de polymériser avec le premier monomère.

A titre de deuxième comonomère, on peut citer :
- une des α-oléfines déjà citées, celle-ci étant différente du premier comonomère α-oléfine,
- les diènes tels que par exemple le 1,4-hexadiène, l'éthylidène norbornène, le butadiène
- les esters d'acides carboxyliques insaturés tels que par exemple les acrylates d'alkyle ou les méthacrylates d'alkyle regroupés sous le terme (méth)acrylates d'alkyles. Les chaînes alkyles de ces (méth)acrylates peuvent avoir jusqu'à 30 atomes de carbone. On peut citer comme chaînes alkyles le méthyle, l'éthyle, le propyl, n-butyl, sec-butyl, Isobutyl, tert-butyl, pentyl, hexyl, heptyl, octyl, 2-ethylhexyl, nonyl, decyl, undecyl, dodecyl, tridecyl, tetradecyl, pentadecyl, hexadecyl, heptadecyl, octadecyl, nonadecyl, eicosyl, hencosyl, docosyl, tricosyl, tetracosyl, pentacosyl, hexacosyl, heptacosyl, octacosyl, nonacosyl. On préfère les (méth)acrylates de méthyle, éthyle et butyle comme esters d'acide carboxylique insaturés.
- les esters vinyliques d'acide carboxyliques. A titre d'exemples d'esters vinyliques d'acide carboxylique, on peut citer l'acétate de vinyle, le versatate de vinyle, le propionate de vinyle, le butyrate de vinyle, ou le maléate de vinyle. On préfère l'acétate de vinyle comme ester vinylique d'acide carboxylique.

Avantageusement, le tronc en polyoléfine comprend au moins 50 % en moles du premier comonomère ; sa densité peut être avantageusement comprise entre 0,91 et 0,96.

Les troncs polyoléfines préférés sont constitués d'un copolymère éthylène-(méth)acrylate d'alkyle. En utilisant ce tronc polyoléfine, on obtient une excellente tenue au vieillissement à la lumière et à la température.

On ne sortirait pas du cadre de l'invention si différents « deuxièmes comonomères » étaient copolymérisés dans le tronc polyoléfine.

Selon la présente invention, le tronc polyoléfine contient au moins un reste de monomère insaturé (X) pouvant réagir sur une fonction acide et/ou amine du greffon polyamide par une réaction de condensation. Selon la définition de l'invention, le monomère insaturé (X) n'est pas un « deuxième comonomère ».

Comme monomère insaturé (X) compris sur le tronc polyoléfine, on peut citer :
- les époxydes insaturés. Parmi ceux-ci, ce sont par exemple les esters et éthers de glycidyle aliphatiques tels que l'allylglycidyléther, le vinylglycidyléther, le maléate et l'itaconate de glycidyle, l'acrylate et le méthacrylate de glycidyle. Ce sont aussi par exemple les esters et éthers de glycidyle alicycliques tels que le 2-cyclohexène-1-glycidyléther, le cyclohexène-4,5-diglycidylcarboxylate, le cyclohexène-4-glycidyl carboxylate, le 5-norbornène-2-méthyl-2-glycidyl carboxylate et l'endocis-bicyclo(2,2,1)-5-heptène-2,3-diglycidyl dicarboxylate. On préfère utiliser le méthacrylate de glycidyle comme époxyde insaturé.
- les acides carboxyliques insaturés et leurs sels, par exemple l'acide acrylique ou l'acide méthacrylique et les sels de ces mêmes acides.
- les anhydrides d'acide carboxylique. Ils peuvent être choisis par exemple parmi les anhydrides maléique, itaconique, citraconique, allylsuccinique, cyclohex-4-ène-1,2-dicarboxylique, 4-méthylènecyclohex-4-ène-1,2-dicarboxylique, bicyclo(2,2,1)hept-5-ène-2,3-dicarboxylique, et x-méthylbicyclo(2,2,1)hept-5-ène-2,2-dicarboxylique. On préfère utiliser l'anhydride maléique comme anhydride d'acide carboxylique.

Le monomère insaturé (X) est de préférence choisi parmi un anhydride d'acide carboxylique insaturé et un époxyde insaturé. En particulier, pour réaliser la condensation du greffon polyamide avec le tronc polyoléfine, dans le cas où l'extrémité réactive du greffon en polyamide est une fonction acide carboxylique, le monomère insaturé (X) est préférentiellement un époxyde insaturé. Dans le cas où l'extrémité réactive du greffon en polyamide est une fonction amine, le monomère insaturé (X) est avantageusement un époxyde insaturé et préférentiellement un anhydride d'acide carboxylique insaturé.

Selon une version avantageuse de l'invention, le nombre préféré de monomère insaturé (X) fixé en moyenne sur le tronc polyoléfine est supérieur ou égal à 1,3 et/ou préférentiellement inférieur ou égal à 20.

Ainsi, si (X) est l'anhydride maléique et la masse molaire en nombre de la polyoléfine est 15 000 g/mol, on a trouvé que ceci correspondait à une proportion d'anhydride d'au moins 0,8 % en masse de l'ensemble du tronc de polyoléfine et d'au plus 6,5%. Ces valeurs associées à la masse des greffons polyamide déterminent la proportion de polyamide et de tronc dans le polymère greffé polyamide.

Le tronc polyoléfine contenant le reste du monomère insaturé (X) est obtenu par polymérisation des monomères (premier comonomère, deuxième comonomère éventuel, et éventuellement monomère insaturé (X)). On peut réaliser cette polymérisation par un procédé radicalaire à haute pression ou un procédé en solution, en réacteur autoclave ou tubulaire, ces procédés et réacteurs étant bien connus de l'homme du métier. Lorsque le monomère insaturé (X) n'est pas copolymérisé dans le tronc polyoléfine, il est greffé sur le tronc polyoléfine. Le greffage est également une opération connue en soi. La composition serait conforme à l'invention si plusieurs monomères fonctionnels (X) différents étaient copolymérisés et/ou greffés sur le tronc polyoléfine.

Selon les types et ratio de monomères, le tronc polyoléfine peut être semi-cristallin ou amorphe. Dans le cas des polyoléfines amorphes, seule la température de transition vitreuse est observée, tandis que dans celui des polyoléfines semi-cristallins une température de transition vitreuse et une température de fusion (qui sera nécessairement supérieure) sont observées. Il suffira à l'homme du métier de sélectionner les ratios de monomère et les masses moléculaires du tronc polyoléfine pour pouvoir obtenir aisément les valeurs voulues de température de transition vitreuse, éventuellement de température de fusion ainsi que de viscosité du tronc polyoléfine.

De manière préférée, la polyoléfine a un Melt Flow Index (MFI) compris entre 3 et 400g/10min (190°C, 2, 16kg, ASTM D 1238).

Les greffons polyamides sont ici choisis pour présenter une température de transition vitreuse et de fusion inférieure à 160°C.

On peut notamment citer les homopolyamides cycloaliphatiques qui résultent de la condensation d'une diamine cycloaliphatique et d'un diacide aliphatique.

A titre d'exemple de diamine cycloaliphatique, on peut citer la 4,4'-méthylene-bis(cyclohexylamine), encore dénommée para-bis(aminocyclo-hexyl)méthane ou PACM, la 2,2'-diméthyl-4,4'méthylène-bis(cyclo-hexyl-amine), encore dénommée bis-(3-méthyl-4-aminocyclohexyl)-méthane ou BMACM.

Ainsi, parmi les homopolyamides cycloaliphatiques, on peut citer les polyamides PACM.12, résultant de la condensation du PACM avec le diacide en C12, les BMACM.10 et BMACM.12 résultant de la condensation de la BMACM avec, respectivement, les diacides aliphatiques en C10 et en C12. Tous ces composés sont connus de l'homme du métier.

Les greffons polyamide rentrant en jeu dans la composition selon l'invention sont préférentiellement des copolyamides. Ceux-ci résultent de la polycondensation d'au moins deux des groupes de monomères énoncés ci-dessus pour l'obtention d'homopolyamides. Le terme « monomère » dans la présente description des copolyamides doit être pris au sens d' « unité répétitive ». En effet, le cas où une unité répétitive du PA est constituée de l'association d'un diacide avec une diamine est particulier. On considère que c'est l'association d'une diamine et d'un diacide, c'est-à-dire le couple diamine-diacide (en quantité équimolaire), qui correspond au monomère. Ceci s'explique par le fait qu'individuellement, le diacide ou la diamine n'est qu'une unité structurale, qui ne suffit pas à elle seule à polymériser pour donner un polyamide.

Ainsi, les copolyamides couvrent notamment les produits de condensation :
- d'au moins deux lactames,
- d'au moins deux acides alpha, omega-aminocarboxyliques aliphatiques,
- d'au moins un lactame et d'au moins un acide alpha, omega-aminocarboxylique aliphatique,
- d'au moins deux diamines et d'au moins deux diacides,
- d'au moins un lactame avec au moins une diamine et au moins un diacide,
- d'au moins un acide alpha,omega-aminocarboxylique aliphatique avec au moins une diamine et au moins un diacide,
la(les) diamine(s) et le(s) diacide(s) pouvant être, indépendamment l'un de l'autre, aliphatiques, cycloaliphatiques ou aromatiques.

Selon les types et ratio de monomères, les copolyamides peuvent être semi-cristallins ou amorphes. Dans le cas des copolyamides amorphes, seule la température de transition vitreuse est observée, tandis que dans celui des copolyamides semi-cristallins une température de transition vitreuse et une température de fusion (qui sera nécessairement supérieure) sont observées.

Parmi les copolyamides, on pourra également utiliser les copolyamides semi-cristallins et particulièrement ceux de type PA 6/11, PA6/12 et PA6/11/12.

Le degré de polymérisation peut varier dans de larges proportions, selon sa valeur c'est un polyamide ou un oligomère de polyamide.

Avantageusement, les greffons polyamide sont mono fonctionnels.

Pour que le greffon polyamide ait une terminaison monoamine, il suffit d'utiliser un limiteur de chaîne de formule : 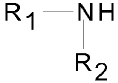 dans laquelle :
- R1 est l'hydrogène ou un groupement alkyle linéaire ou ramifié contenant jusqu'à 20 atomes de carbone,
- R2 est un groupement ayant jusqu'à 20 atomes de carbone alkyle ou alcényle linéaire ou ramifié, un radical cycloaliphatique saturé ou non, un radical aromatique ou une combinaison des précédents. Le limiteur peut être, par exemple, la laurylamine ou l'oleylamine.

Pour que le greffon polyamide ait une terminaison monoacide carboxylique, il suffit d'utiliser un limiteur de chaîne de formule R'1-COOH, R'1-CO-O-CO-R'2 ou un diacide carboxylique.

R'1 et R'2 sont des groupements alkyles linéaires ou ramifiés contenant jusqu'à 20 atomes de carbone.

Avantageusement, le greffon polyamide possède une extrémité à fonctionnalité amine. Les limiteurs monofonctionnels de polymérisation préférés sont la laurylamine et l'oléylamine.

Les greffons polyamides ont une masse molaire comprise entre 1000 et 10000 g/mol. Etant donné que le rapport stoechiométrique pour le greffage des greffons polyamide sur le tronc polyoléfine est constant, le choix de la masse des greffons polyamide est fonction de la masse de polyamide désirée dans la composition selon ce qui a été expliqué précédemment.

Il suffira à l'homme du métier de sélectionner les types et ratio de monomères ainsi que choisir les masses molaires des greffons polyamide pour pouvoir obtenir aisément les valeurs voulues de température de transition vitreuse, éventuellement de température de fusion ainsi que de viscosité du greffon polyamide.

La réaction de condensation du greffon polyamide sur le tronc de polyoléfine contenant le reste de X s'effectue par réaction d'une fonction amine ou acide du greffon polyamide sur le reste de X. Avantageusement, on utilise des greffons polyamide monoamine et on crée des liaisons amides ou imides en faisant réagir la fonction amine sur la fonction du reste de X.

On réalise cette condensation de préférence à l'état fondu. Pour fabriquer la composition selon l'invention, on peut utiliser les techniques classiques de malaxage et/ou d'extrusion. Les composants de la composition sont ainsi mélangés pour former un compound qui pourra éventuellement être granulé en sortie de filière. Avantageusement, des agents de couplage sont ajoutés lors du compoundage.

Pour obtenir une composition nanostructurée, on peut ainsi mélanger le greffon polyamide et le tronc dans une extrudeuse, à une température généralement comprise entre 200 et 300 °C. Le temps de séjour moyen de la matière fondue dans l'extrudeuse peut être compris entre 5 secondes et 5 minutes, et de préférence entre 20 secondes et 1 minute. Le rendement de cette réaction de condensation est évalué par extraction sélective des greffons de polyamide libres, c'est-à-dire ceux qui n'ont pas réagi pour former le polymère greffé polyamide.

La préparation de greffons polyamide à extrémité amine ainsi que leur addition sur un tronc de polyoléfine contenant le reste de (X) est décrite dans les brevets US3976720, US3963799, US5342886 et FR2291225. Le polymère greffé polyamide de la présente invention présente avantageusement une organisation nanostructurée.

S'agissant du second polymère, il s'agit d'un - le second polymère, présent dans la composition à hauteur d'au moins 10 % en poids, consiste en un copolymère d'éthylène et d'un comonomère non réactif ou non fonctionnalisé dont le module élastique en flexion est inférieur à 250 Mpa à 23°C et qui présente un point de fusion cristalline compris entre 60°C et 120°C.

Avantageusement, selon un mode d'exécution, ce second polymère consiste en un copolymère de l'éthylène et d'un (méth)acrylate d'alkyle.

Autrement dit, ce second polymère consiste en un homopolymère d'une oléfine ou un copolymère d'au moins une alphaoléfine et d'au moins un autre monomère copolymérisable, pourvu bien sûr que les conditions de module et de point de fusion cristalline soient respectés.

Avantageusement la polyoléfine souple est choisie parmi les polyéthylènes homo- ou copolymères.

A titre de comonomères, on peut citer :
- les alpha-oléfines, avantageusement celles ayant de 3 à 30 atomes de carbone.

Des exemples d'alpha-oléfines ayant 3 à 30 atomes de carbone comme comonomères éventuels comprennent le propylène, 1-butène, 1-pentène, 3-méthyl-1-butène, 1-hexène, 4-méthyl-1-pentène, 3-méthyl-1-pentène, 1-octène, 1-décène, 1-dodécène, 1-tétradécène, 1-hexadécène, 1-octadécène, 1-eicocène, 1-dococène, 1-tétracocène, 1-hexacocène, 1-octacocène, et 1-triacontène. Ces alpha-oléfines peuvent être utilisées seules ou en mélange de deux ou de plus de deux.
- les esters d'acides carboxyliques insaturés tels que par exemple les (méth)acrylates d'alkyle, les alkyles pouvant avoir jusqu'à 24 atomes de carbone.

Des exemples d'acrylate ou méthacrylate d'alkyle sont notamment le méthacrylate de méthyle, l'acrylate d'éthyle, l'acrylate de n-butyle, l'acrylate d'isobutyle, l'acrylate de 2-éthylhexyle.
- les esters vinyliques d'acides carboxyliques saturés tels que par exemple l'acétate ou le propionate de vinyle.
- les diènes tels que par exemple le 1,4-hexadiène.
La polyoléfine souple peut comprendre plusieurs comonomères.

A titre d'exemple on peut citer :
- le polyéthylène basse densité (LDPE)
- le polyéthylène linéaire basse densité (LLDPE)
- le polyéthylène très basse densité (VLDPE)
- le polyéthylène obtenu par catalyse métallocène, c'est-à-dire les polymères obtenus par copolymérisation d'éthylène et d'alphaoléfine telle que propylène, butène, héxène ou octène en présence d'un catalyseur monosite constitué généralement d'un atome de zirconium ou de titane et de deux molécules cycliques alkyles liées au métal. Plus spécifiquement, les catalyseurs métallocènes sont habituellement composés de deux cycles cyclopentadiéniques liés au métal. Ces catalyseurs sont fréquemment utilisés avec des aluminoxanes comme cocatalyseurs ou activateurs, de préférence le méthylaluminoxane (MAO). Le hafnium peut aussi être utilisé comme métal auquel le cyclopentadiène est fixé. D'autres métallocènes peuvent inclure des métaux de transition des groupes IV A, V A, et VI A. Des métaux de la série des lanthamides peuvent aussi être utilisés.
- les élastomères EPR (éthylène - propylène - rubber)
- les élastomères EPDM (éthylène - propylène - diène)
- les mélanges de polyéthylène avec un EPR ou un EPDM
- les copolymères éthylène-(méth)acrylate d'alkyle pouvant contenir jusqu'à 60% en poids de (méth)acrylate et de préférence 2 à 40%

A titre d'exemple on peut citer les copolymères souples de l'éthylène tels que les copolymères obtenus par voie radicalaire sous haute pression de l'éthylène avec de l'acétate de vinyle, des esters (meth)acryliques de l'acide (meth)acrylique et d'un alcool ayant de 1 à 24 atomes de carbone et avantageusement de 1 à 9, les terpolymères radicalaires utilisant en plus un troisième monomère choisi par les monomères insaturés copolymérisables avec l'éthylène tels que l'acide acrylique, l'anhydride maléique, le méthacrylate de glycidyle. Ces copolymères souples peuvent aussi être des copolymères de l'éthylène avec des alfa-oléfines de 3 à 8 atomes de carbone tels que les EPR, les copolymères de très basse densité de l'éthylène avec du butène de l'hexène ou de l'octène de densité comprise entre 0.870 et 0.910 g/cm³ obtenues par catalyse metallocène ou Ziegler - Natta. Par polyoléfines souples , nous entendons également les mélanges de 2 ou plusieurs polyoléfines souples.

L'invention est particulièrement utile pour les copolymères de l'éthylène et des (méth)acrylates d'alkyle. L'alkyle peut avoir jusqu'à 24 atomes de carbone. De préférence les (méth)acrylates sont choisis parmi ceux cités plus haut. Ces copolymères comprennent avantageusement jusqu'à 40 % en poids de (méth)acrylate et de préférence 3 à 35 %. Leur MFI est avantageusement compris entre 0,1 et 50 (à 190°C - 2,16 kg).

Avantageusement, le module de flexion est compris entre 5 et 150 MPa.

S'agissant du troisième polymère, optionnel selon l'invention, il s'agit d'une polyoléfine fonctionnalisée comprenant un copolymère d'au moins une alpha-oléfine, telle que l'éthylène ou le propylène, avec au moins un comonomère portant une fonction réactive, choisi notamment parmi un acide carboxylique, tel que l'acide (méth)acrylique, un anhydride carboxylique, tel que l'anhydride maléique, ou un époxyde, tel que le (méth)acrylate de glycidyle, et au moins un autre comonomère ne portant pas de fonction réactive, choisi par exemple parmi une alpha-oléfine différente ; un diène tel que le butadiène ; un ester d'acide carboxylique insaturé, tel qu'un (méth)acrylate d'alkyle où le groupe alkyle peut être un groupe méthyle, éthyle ou butyle, notamment ; et un ester vinylique d'acide carboxylique, tel que l'acétate de vinyle.

A titre d'exemple de comonomère réactif on peut citer :
- les époxydes insaturés.

Des exemples d'époxydes insaturés sont notamment :
- les esters et éthers de glycidyle aliphatiques tels que l'allylglycidyléther, le vinylglycidyléther, le maléate et l'itaconate de glycidyle, l'acrylate et le méthacrylate de glycidyle, et
- les esters et éthers de glycidyle alicycliques tels que le 2-cyclohexène-1-glycidyléther, le cyclohexène-4,5-diglycidylcarboxylate, le cyclohexène-4-glycidyl carboxylate, le 5-norbornène-2-méthyl-2-glycidyl carboxylate et l'endocis-bicyclo(2,2,1)-5-heptène-2,3-diglycidyl dicarboxylate.
- les acides carboxyliques insaturés, leurs sels, leurs anhydrides.

Des exemples d'anhydrides d'acide dicarboxylique insaturé sont notamment l'anhydride maléique, l'anhydride itaconique, l'anhydride citraconique, l'anhydride tétrahydrophtalique.

A titre d'exemple de copolymère comprenant un comonomère réactif on peut citer :
- les copolymères éthylène (méth)acrylate d'alkyle-anhydride maléique obtenus par copolymérisation des trois monomères, les proportions de (méth)acrylate étant comme les copolymères ci-dessus, la quantité d'anhydride maléique étant jusqu'à 10% et de préférence 0,2 à 6% en poids.
- les copolymères éthylène-acétate de vinyle-anhydride maléique obtenus par copolymérisation des trois monomères, les proportions étant les mêmes que dans le copolymère précédent.

On préfère que la polyoléfine fonctionnalisée renferme de 60 à 100% en poids d'alpha-oléfine et de 0 à 40% en poids, de préférence de 0 à 15% en poids, de comonomère ne portant pas de fonction réactive. On préfère en outre que la polyoléfine fonctionnalisée renferme de 0,1 à 15% en poids, de préférence de 0,5 à 5% en poids, de comonomère portant une fonction réactive. Des exemples de telles polyoléfines fonctionnalisées sont les copolymères éthylène / ester acrylique / méthacrylate de glycidyle et éthylène / ester acrylique / anhydride maléique, respectivement disponibles auprès de la société ARKEMA sous la dénomination commerciale Lotader® GMA et Lotader® MAH.

Des compléments, ou adjuvants, pourront éventuellement être ajoutés à la composition selon l'invention afin de conférer à cette dernière telle ou telle fonctionnalité complémentaire.

Dans cette application particulière de la composition aux modules photovoltaïques, le rayonnement UV (Ultra Violet) étant susceptible d'entraîner un léger jaunissement de la composition utilisée, des stabilisants UV et des absorbeurs UV tels que le benzotriazole, le benzophénone et les autres amines encombrés, peuvent être ajoutés afin d'assurer la transparence de l'encapsulant durant sa durée de vie. Ces composés peuvent être par exemple à base de benzophénone ou de benzotriazole. On peut les ajouter dans des quantités inférieures à 10% en masse de la masse totale de la composition et préférentiellement de 0,1 à 5%.

On pourra également ajouter des antioxydants pour limiter le jaunissement lors de la fabrication de l'encapsulant tels que les composés phosphorés (phosphonites et/ou phosphites) et les phénoliques encombrés. On peut ajouter ces antioxydants dans des quantités inférieures à 10% en masse de la masse totale de la composition et préférentiellement de 0,1 à 5%.

Des agents retardateurs de flamme peuvent également être ajoutés. Ces agents peuvent être halogénés ou non-halogénés. Parmi les agents halogénés, on peut citer les produits bromés. On peut également utiliser comme agent non-halogéné les additifs à base de phosphore tels que le phosphate d'ammonium, de polyphosphate, de phosphinate ou de pyrophosphate, le cyanurate de mélamine, le pentaérythritol, les zéolithes ainsi que les mélanges de ces agents. La composition peut comprendre ces agents dans des proportions allant de 3 à 40% par rapport à la masse totale de la composition.

Si cela est souhaité dans une application particulière, on peut également ajouter des pigments comme par exemple des composés colorants ou azurants dans des proportions allant généralement de 5 à 15% par rapport à la masse totale de la composition.

Concernant les autres aspects de l'invention relatifs à l'utilisation de la composition selon l'invention dans un module photovoltaïque, l'Homme de l'Art peut se référer par exemple au « Handbook of Photovoltaic Science and Engineering », Wiley, 2003 volume 7.

### Préparation de la composition selon l'invention :

La technique de greffage des greffons polyamide sur le tronc polyoléfine pour obtenir la polyoléfine greffé polyamide selon l'invention est bien connu de l'homme du métier, et notamment des documents cités précédemment FR 2912150, FR 2918150 ou EP 21966489.

On ne sort donc pas du cadre de l'invention si des agents réticulant sont ajoutés. On peut citer comme exemples des isocyanates ou des peroxydes organiques. Cette réticulation peut également être réalisée par des techniques connues d'irradiation. Cette réticulation peut être effectuée par l'une des nombreuses méthodes connues de l'homme du métier, notamment par l'utilisation d'initiateurs activés thermiquement, par exemple des composés peroxydes et azo, des photoinitiateurs tels que le benzophénone, par des techniques de radiation comportant des rayons lumineux, des rayons UV, des faisceaux d'électrons et des rayons X, de silanes porteurs de fonctions réactives comme un amino silane, un époxy silane, un vinyle silane tel que par exemple le vinyle silane tri-éthoxy ou tri-méthoxy, et de la réticulation par voie humide. Le manuel intitulé « Handbook of polymer foams and technology » supra, aux pages 198 à 204, fournit des enseignements complémentaires auxquels l'homme du métier peut se référer.

Concernant les aspects de l'invention relatifs à l'utilisation de la composition thermoplastique dans un module photovoltaïque, l'Homme de l'Art peut se référer par exemple au Handbook of Photovoltaic Science and Engineering, Wiley, 2003. En effet, la composition de l'invention peut être utilisée en tant qu'encapsulant ou encapsulant-backsheet dans un module photovoltaïque, dont on décrit la structure en relation avec les figures annexées.

### Matériaux employés pour former les formulations testées :

**Lotader® 7500:** terpolymère d'éthylène, d'acrylate d'éthyle (17,5 % en poids) et d'anhydride maléique (2,8 % en poids) produit par ARKEMA possédant un MFI (190°C sous 2,16 kg mesuré selon ISO 1133) de 70 g/10 mn (minute).
**Lotader® 5500:** terpolymère d'éthylène, d'acrylate d'éthyle (20 % en poids) et d'anhydride maléique (2,8 % en poids) produit par ARKEMA possédant un MFI (190°C sous 2,16 kg mesuré selon ISO 1133) de 20 g/10 mn.
**Lotryl® 17 BA07:** copolymère d'éthylène et d'acrylate de butyle (17 % en poids) produit par ARKEMA possédant un MFI (190°C sous 2,16 kg mesuré selon ISO 1133) de 7 g/ 10 mn.
**Lotryl® 18MA02:** copolymère d'éthylène et d'acrylate de méthyle (18 % en poids) produit par ARKEMA possédant un MFI (190°C sous 2,16 kg mesuré selon ISO 1133) de 2 g/10 mn.
**Elvaloy® AC 1820** : copolymère d'éthylène et d'acrylate de méthyle (20 % en poids) produit par Dupont possédant un MFI (190°C sous 2,16 kg mesuré selon ISO 1133) de 8 g/10 mn.
**Prépolymère PA6** : Un prépolymère PA6 a été synthétisé par polycondensation à partir du lactame 6. La laurylamine est utilisée comme limitateur de chaîne de façon à avoir une seule fonctionnalité amine primaire en bout de chaîne. La masse molaire moyenne en nombre du premier prépolymère est de 2500 g/mol.
**Prépolymère copolyamide 6/12 à température de fusion 130°C :** un prépolymère copolyamide 6/12 a été synthétisé par polycondensation à partir du lactame 6 et du lactame 12. Le ratio lactame 6/lactame 12 est ajusté pour obtenir une température de fusion de 130°C. La laurylamine est utilisée comme limitateur de chaîne de façon à avoir une seule fonctionnalité amine primaire en bout de chaîne. Sa masse molaire moyenne en nombre est de 2500 g/mol.
**Prépolymère copolyamide 6/11 à température de fusion 150°C** : un prépolymère copolyamide 6/11 a été synthétisé par polycondensation à partir du lactame 6 et de l'amino 11. Le ratio lactame 6/amino 11 est ajusté pour obtenir une température de fusion de 150°C. La laurylamine est utilisée comme limitateur de chaîne de façon à avoir une seule fonctionnalité amine primaire en bout de chaîne. Sa masse molaire moyenne en nombre est de 3200 g/mol.
**Apolhya®:** La famille Apolhya est une famille de polymères commercialisée par ARKEMA qui allient les propriétés des polyamides à celles des polyoléfines grâce à l'obtention de morphologies co-continues à l'échelle manométrique. Dans le cadre des tests, il est retenu plusieurs types d'Apolhya® :
- Apolhya **A** sur la base du Lotader® 7500 et du copolyamide 6/12 de température de fusion de 130°C contenant 20% en poids de copolyamide.
- Apolhya **B** sur la base du Lotader® 7500 et du copolyamide 6/11 de température de fusion de 150°C contenant 20% en poids de polyamide.
- Apolhya **C** sur la base du Lotader® 7500 et du polyamide 6 de température de fusion de 220°C contenant 20% en poids de polyamide.
- Apolhya **D** sur la base du Lotader® 7500 et du polyamide 11 de température de fusion de 190°C contenant 20% en poids de copolyamide.
- Apolhya **E** sur la base du Lotader® 7500 et du polyamide 6/12 de température de fusion de 130°C contenant 50% en poids de copolyamide.
- Apolhya **F** sur la base du Lotader® 5500 et du polyamide 6/12 de température de fusion de 130°C contenant 20% en poids de copolyamide.

| Compositions | Taux de polyamide dans la composition (% massique) | Apolhya | | | | | | Lotryl 17BA07 | Lotryl 18MA02 | Elvaloy AC 1820 | Lotader 5500 | Lotader 7500 |
|---|---|---|---|---|---|---|---|---|---|---|---|---|
| | | A | B | C | D | E | F | | | | | |
| Exemple 1 | 3,5 | 17,5 | | | | | | 72,5 | | | 10 | |
| Exemple 2 | 6 | 30 | | | | | | 60 | | | 10 | |
| Exemple 3 | 11 | 55 | | | | | | 35 | | | | 10 |
| Exemple 4 | 11 | 55 | | | | | | 35 | | | | 10 |
| Exemple 5 | 12,5 | 62,5 | | | | | | 27,5 | | | 10 | |
| Exemple 6 | 8 | | | | | 16 | | | 60 | | 24 | |
| Exemple 7 | 8 | | | | | 16 | | | | 60 | | 24 |
| Exemple 8 | 7,5 | | | | | | 37, 5 | 12,5 | 40 | | 10 | |
| Exemple 9 | 8 | 40 | | | | | | | | 50 | | 10 |
| Exemple 10 | 8 | | | | | 16 | | | 79 | | | 5 |
| Exemple comparatif 1 | 2 | 10 | | | | | | 90 | | | | |
| Exemple comparatif 2 | 17 | 85 | | | | | | 15 | | | | |
| Exemple comparatif 3 | 20 | | 100 | | | | | | | | | |
| Exemple comparatif 4 | 13 | | | 65 | | | | 35 | | | | |
| Exemple comparatif 5 | 13 | | | | 65 | | | 35 | | | | |

### Obtention des formulations et films testés :

### • Extrusion réactive des formulations

### ∘ Extrusion réactive des formulations Apolhya sur base Lotader 7500 ou Lotader 5000 et copolyamides 6/12 et 6/11

Ces formulations Apolhya® ont été préparées par « compoundage » grâce à une extrudeuse double vis co-rotative de type Leistritz® (L/D=35) dont les éléments de fourreaux sont chauffés selon un profil plat à 190°C; la vitesse de rotation est de 300 rpm (« round per minute » ou Tour Par Minute) avec un débit de 15 kg/h (kilogramme par heure).

### ∘ Extrusion réactive des formulations Apolhya sur base Lotader 7500 et polyamide 6

Ces formulations Apolhya® ont été préparées par « compoundage » grâce à une extrudeuse double vis co-rotative de type Leistritz® (L/D=35) dont les éléments de fourreaux sont chauffés selon un profil plat à 240°C ; la vitesse de rotation est de 300 rpm (« round per minute » ou Tour Par Minute) avec un débit de 15 kg/h (kilogramme par heure).

### • Extrusion de films monocouches de 400 µm des compositions Apolhya/polyoléfine(s) de l'invention et des exemples comparatifs

Des films monocouches de 400 µm (micromètre) ont été réalisés par extrusion de film à plat sur une petite ligne d'extrusion de laboratoire. Les compositions sont obtenues par mélange d'une polyoléfine greffée polyamide, d'un copolymère d'éthylène et d'un acrylate d'alkyle et éventuellement d'une troisième polyoléfine fonctionnalisée à l'anhydride maléique. Les proportions entre les constituants sont assurées en réalisant un mélange à sec en sac des granulés préalable à l'extrusion.

L'extrudeuse est une bi-vis contrarotative de type Haake 1 équipée d'une filière plate de 10 cm (centimètre) de large et de 0,5 mm (millimètre) d'ouverture. Les éléments de fourreaux sont chauffés selon un profil plat à 160°C pour les exemples illustratifs de l'invention à base de copolyamide 6/12 ; la vitesse de rotation des vis étant de 60 rpm (tour par minute ou « round per minute »). Pour les contre-exemples de l'invention à base de polyamide 6, les éléments de fourreaux sont chauffés selon un profil plat à 220°C la vitesse de rotation des vis étant de 60 rpm. Pour les contre-exemples de l'invention à base de polyamide 6/11, les éléments de fourreaux sont chauffés selon un profil plat à 180°C, la vitesse de rotation des vis étant de 60 rpm.

### Tests réalisés sur les films :

### Test de reprise en eau :

Le test de reprise en humidité consiste à mesurer le taux d'humidité obtenu à saturation dans un film de 400 µm (micromètre) après un conditionnement réalisé en chaleur humide à 85°C et 85 % d'humidité relative (HR). La mesure du taux d'humidité est effectuée selon la méthode Karl-Fisher basée sur la norme ISO 15512. Pour mesurer le taux d'humidité absorbée, le film est soumis à une étape de désorption thermique sous azote pendant 20 minutes à 200°C.

### Résultats de reprise en eau pour les différents échantillons :

| Compositions | Taux d'humidité (%) |
|---|---|
| Exemple 1 | 0,25 |
| Exemple 2 | 0,31 |
| Exemple 3 | 0,41 |
| Exemple 4 | 0,41 |
| Exemple 5 | 0,43 |
| Exemple 6 | 0,31 |
| Exemple 7 | 0,32 |
| Exemple 8 | 0,32 |
| Exemple 9 | 0,37 |
| Exemple 10 | 0,29 |
| Contre-exemple 1 | 0,20 |
| Contre-exemple 2 | 0,54 |
| Contre-exemple 3 | 0,60 |
| Contre-exemple 4 | 0,58 |
| Contre-exemple 5 | 0,45 |

Le tableau de résultat ci-dessus montre de façon schématique comment la composition selon l'invention a été établie. Un résultat supérieur à 0,50 % sur le test en reprise en eau est disqualifiant pour la composition, dans l'application en question ; étant entendu que pour un grand nombre d'autres applications, ce même seuil disqualifiant de 0,50 % pour ce test est susceptible de s'appliquer.

Les domaines de composition préférés pour la composition selon l'invention ont été établis non seulement sur la base de ce test en reprise en eau mais également sur des tests de propriétés thermomécaniques tels qu'un test de fluage à 100°C, de MFI (« Melt Flow Index ») ainsi que sur des tests relatifs aux propriétés optiques (test de transparence, de jaunissement en vieillissement accéléré).

Il a également été constaté que les formulations selon l'invention, à savoir les exemples de compositions 1 à 10, montrent d'excellentes propriétés adhésives sur verre, notamment après un test de vieillissement en chaleur humide à 85°C et 85% HR (« Humidity Rate » ou Taux d'Humidité).

Il est important de noter que, contrairement au résultat plutôt satisfaisant concernant l'exemple comparatif 1, ce dernier est impropre à l'application car sa résistance au fluage est insuffisante.

L'exemple comparatif 4 est impropre à l'application car la reprise en humidité est trop élevée et la température de fusion du polyamide est inadaptée à l'application. Le produit ne s'écoule pas aux températures usuelles de fabrication des panneaux photovoltaïques.

L'exemple comparatif 5 est impropre à l'application car la température de fusion du polyamide est inadaptée à l'application. En effet, le produit ne s'écoule pas aux températures usuelles de fabrication des panneaux photovoltaïques.

## Revendications

1. Composition thermoplastique comprenant au moins un mélange de trois polymères, dans laquelle :
- le premier polymère, présent dans la composition entre 10% et 70% en poids, consiste en un polymère greffé polyamide présentant un tronc en polyoléfine contenant un reste d'au moins un monomère insaturé (X) et une pluralité de greffons en polyamide, dans lequel :
- les greffons en polyamide sont attachés au tronc en polyoléfine par le reste du monomère insaturé (X) comprenant une fonction capable de réagir par une réaction de condensation avec un polyamide ayant au moins une extrémité amine et/ou au moins une extrémité acide carboxylique,
- le reste du monomère insaturé (X) est fixé sur le tronc par greffage ou copolymérisation,
- les greffons en polyamide représentent de 10% à 60%, de préférence de 15% à 55%, en poids dudit polymère greffé polyamide,
- le second polymère, présent dans la composition à hauteur d'au moins 10 % en poids, consiste en un copolymère d'éthylène et d'un comonomère non réactif ou non fonctionnalisé dont le module élastique en flexion est inférieur à 250 Mpa à 23°C et qui présente un point de fusion cristalline compris entre 60°C et 120°C,
- le troisième polymère, présent dans la composition entre 3 % et 45 % en poids de ladite composition, consistant en une polyoléfine fonctionnalisée comprenant un copolymère d'au moins une alpha-oléfine, telle que l'éthylène ou le propylène, avec au moins un comonomère portant une fonction réactive, et au moins un autre comonomère ne portant pas de fonction réactive, choisi parmi une alpha-oléfine différente de la susdite alpha-oléfine, un diène, un ester d'acide carboxylique insaturé, et un ester vinylique d'acide carboxylique, **caractérisée en ce que** les greffons en polyamide du susdit premier polymère présentent une température de transition vitreuse ainsi qu'une température de fusion inférieures ou égale à 160°C,
et **en ce que** le taux des greffons polyamide dudit premier polymère représente de 3 % à 15 %, de préférence entre 5 % et 12,5 %, en poids de la composition thermoplastique.

2. Composition selon la revendication 1, **caractérisée en ce que** le second polymère consiste en un copolymère de l'éthylène et d'un (méth)acrylate d'alkyle.

3. Composition selon la revendication 1 ou 2, **caractérisée en ce que** la masse molaire en nombre des susdits greffons polyamide du susdit polymère greffé est comprise dans la gamme allant de 1000 à 10000 g/mol.

4. Composition selon l'une quelconque des revendications précédentes, **caractérisée en ce que**, pour les susdits polymères greffés, le nombre de monomère (X) fixé sur le tronc en polyoléfine est supérieur ou égal à 1,3 et inférieur ou égal à 20.

5. Composition selon l'une quelconque des revendications précédentes, **caractérisée en ce que** le susdit premier polymère est présent dans la composition entre 10% et 50% en poids.

6. Composition selon l'une quelconque des revendications précédentes, **caractérisée en ce que** les greffons polyamide du premier polymère consistent en des copolyamides choisi parmi les copolyamides PA 6/11, PA6/12 et PA6/11/12.

7. Composition selon l'une quelconque des revendications précédentes, **caractérisée en ce que** le troisième polymère consiste en un copolymère éthylène - ester acrylique - méthacrylate de glycidyle ou éthylène - ester acrylique - anhydride maléique.

8. Composition selon l'une quelconque des revendications précédentes, **caractérisée en ce que** le monomère insaturé (X) du premier polymère est un anhydride maléique.

9. Composition selon l'une quelconque des revendications précédentes, **caractérisée en ce que** le second polymère est présent dans la composition entre dans la composition entre 40% et 70% en poids.

10. Composition selon la revendication 8, **caractérisée en ce que** le troisième polymère est présent entre 10% et 30% en poids dans la composition.

11. Composition selon l'une quelconque des revendications précédentes, **caractérisée en ce qu'**elle consiste uniquement en les trois susdits polymères.

12. Film thermoplastique comprenant la composition selon l'une quelconque des revendications précédentes.

13. Film thermoplastique d'un module photovoltaïque, ledit module photovoltaïque comprenant au moins deux couches dont l'une forme la couche d'encapsulant et/ou une couche arrière de protection, **caractérisé en ce que** la couche d'encapsulant comprend, de préférence consiste en, la composition thermoplastique selon l'une quelconque des revendications 1 à 11.

14. Film selon la revendication 13, **caractérisé en ce que** la couche formant encapsulant comprend des promoteurs d'adhésion consistant en un ingrédient non polymérique, de nature organique, cristalline ou minéral et plus préférentiellement semi-minéral semi-organique, des antioxydants et/ou des agents anti-UVs.

## Patentansprüche

1. Thermoplastische Zusammensetzung, die mindestens ein Gemisch von drei Polymeren umfasst, wobei:
- das erste Polymer, das in der Zusammensetzung zu zwischen 10 und 70 Gew.-% vorliegt, aus einem Polyamid-gepfropften Polymer besteht, das einen Polyolefinstamm aufweist, der einen Rest mindestens eines ungesättigten Monomers (X) und eine Mehrzahl Polyamid-Pfropfungen enthält, wobei:
- die Polyamid-Pfropfungen an den Polyolefinstamm über den Rest des ungesättigten Monomers (X) gebunden sind, der eine Funktion umfasst, die über eine Kondensationsreaktion mit einem Polyamid mit mindestens einem endständigen Amin und/oder mindestens einer endständigen Carbonsäure reagieren kann,
- der Rest des ungesättigten Monomers (X) an den Stamm durch Pfropfung oder Copolymerisation gebunden ist,
- die Polyamid-Pfropfungen 10% bis 60%, vorzugsweise 15% bis 55%, bezogen auf das Gewicht des Polyamid-gepfropften Polymers, ausmachen,
- das zweite Polymer, das in der Zusammensetzung in einer Menge von mindestens 10 Gew.-% vorliegt, aus einem Copolymer von Ethylen und einem nicht-reaktiven oder nicht-funktionalisierten Comonomer besteht, dessen Biegeelastizitätsmodul bei 23°C kleiner als 250 MPa ist und das einen Kristallschmelzpunkt zwischen 60°C und 120°C aufweist,
- das dritte Polymer, das in der Zusammensetzung zu zwischen 3% und 45%, bezogen auf das Gewicht der Zusammensetzung, vorliegt, aus einem funktionalisierten Polyolefin besteht, umfassend ein Copolymer von mindestens einem α-Olefin, wie Ethylen oder Propylen, mit mindestens einem Comonomer, das eine reaktive Funktion trägt, und mindestens einem anderen Comonomer, das keine reaktive Funktion trägt, ausgewählt aus einem anderen alpha-Olefin als das vorstehend genannte alpha-Olefin, einem Dien, einem ungesättigten Carbonsäureester und einem Carbonsäurevinylester,
**dadurch gekennzeichnet, dass** die Polyamid-Pfropfungen des vorstehend genannten ersten Polymers eine Glasübergangstemperatur sowie einen Schmelzpunkt von weniger als oder gleich 160°C aufweisen,
und dadurch, dass der Anteil der Polyamid-Pfropfungen des ersten Polymers 3% bis 15%, vorzugsweise zwischen 5% und 12,5%, bezogen auf das Gewicht der thermoplastischen Zusammensetzung, ausmacht.

2. Zusammensetzung nach Anspruch 1, **dadurch gekennzeichnet, dass** das zweite Polymer aus einem Copolymer von Ethylen und einem Alkyl(meth)acrylat besteht.

3. Zusammensetzung nach Anspruch 1 oder 2, **dadurch gekennzeichnet, dass** die zahlenmittlere Molekülmasse der vorstehend genannten Polyamid-Pfropfungen des vorstehend genannten Pfropfpolymers im Bereich von 1000 bis 10000 g/mol liegt.

4. Zusammensetzung nach einem der vorhergehenden Ansprüche, **dadurch gekennzeichnet, dass** für die vorstehend genannten Pfropfpolymere die Anzahl an Monomer (X), das an den Polyolefinstamm gebunden ist, größer als oder gleich 1,3 und kleiner als oder gleich 20 ist.

5. Zusammensetzung nach einem der vorhergehenden Ansprüche, **dadurch gekennzeichnet, dass** das vorstehend genannte erste Polymer in der Zusammensetzung zu zwischen 10 und 50 Gew.-% vorliegt.

6. Zusammensetzung nach einem der vorhergehenden Ansprüche, **dadurch gekennzeichnet, dass** die Polyamid-Pfropfungen des ersten Polymers aus Copolyamiden, ausgewählt aus den Copolyamiden PA 6/11, PA6/12 und PA6/11/12, bestehen.

7. Zusammensetzung nach einem der vorhergehenden Ansprüche, **dadurch gekennzeichnet, dass** das dritte Polymer aus einem Ethylen-Acrylester-Glycidylmethacrylat- oder Ethylen-Acrylester-Maleinsäureanhydrid-Copolymer besteht.

8. Zusammensetzung nach einem der vorhergehenden Ansprüche, **dadurch gekennzeichnet, dass** das ungesättigte Monomer (X) des ersten Polymers ein Maleinsäureanhydrid ist.

9. Zusammensetzung nach einem der vorhergehenden Ansprüche, **dadurch gekennzeichnet, dass** das zweite Polymer in der Zusammensetzung zu zwischen in der Zusammensetzung zu zwischen 40 Gew.-% und 70 Gew.-% vorliegt.

10. Zusammensetzung nach Anspruch 8, **dadurch gekennzeichnet, dass** das dritte Polymer in der Zusammensetzung zu zwischen 10 Gew.-% und 30 Gew.-% vorliegt.

11. Zusammensetzung nach einem der vorhergehenden Ansprüche, **dadurch gekennzeichnet, dass** sie ausschließlich aus den drei vorstehend genannten Polymeren besteht.

12. Thermoplastische Folie, die die Zusammensetzung nach einem der vorhergehenden Ansprüche umfasst.

13. Thermoplastische Folie eines Photovoltaik-Moduls, wobei das Photovoltaik-Modul mindestens zwei Schichten umfasst, von denen eine die Einkapselungsschicht und/oder eine schützende Rückschicht bildet, **dadurch gekennzeichnet, dass** die Einkapselungsschicht die thermoplastische Zusammensetzung nach einem der Ansprüche 1 bis 11 umfasst, vorzugsweise daraus besteht.

14. Folie nach Anspruch 13, **dadurch gekennzeichnet, dass** die die Einkapselung bildende Schicht Haftvermittler, die aus einem nicht-polymeren Bestandteil organischer, kristalliner oder anorganischer und stärker bevorzugt halb-anorganischer halb-organischer Natur bestehen, Antioxidantien und/oder UV-Stabilisatoren umfasst.

## Claims

1. Thermoplastic composition comprising at least a mixture of three polymers, in which:
- the first polymer, present in the composition at between 10% and 70% by weight, consists of a polyamide-grafted polymer having a polyolefin trunk containing a residue of at least one unsaturated monomer (X) and a plurality of polyamide grafts, in which:
- the polyamide grafts are attached to the polyolefin trunk via the unsaturated monomer residue (X) comprising a function that is capable of reacting via a condensation reaction with a polyamide bearing at least one amine end group and/or at least one carboxylic acid end group,
- the unsaturated monomer residue (X) is attached to the trunk by grafting or copolymerization,
- the polyamide grafts represent from 10% to 60% and preferably from 15% to 55% by weight of said polyamide-grafted polymer,
- the second polymer, present in the composition in an amount of at least 10% by weight, consists of a copolymer of ethylene and of an unreactive or non-functionalized comonomer whose flexural elastic modulus is less than 250 MPa at 23°C and which has a crystal melting point of between 60°C and 120°C,
- the third polymer, present in the composition at between 3% and 45% by weight of said composition, consisting of a functionalized polyolefin comprising a copolymer of at least one alpha-olefin, such as ethylene or propylene, with at least one comonomer bearing a reactive function, and at least one other comonomer not bearing a reactive function, chosen from an alpha-olefin different from the abovementioned alpha-olefin, a diene, an unsaturated carboxylic acid ester, and a vinyl ester of a carboxylic acid,
**characterized in that** the polyamide grafts of the abovementioned first polymer have a glass transition temperature and a melting point of less than or equal to 160°C,
and **in that** the content of polyamide grafts in said first polymer represents from 3% to 15% and preferably between 5% and 12.5% by weight of the thermoplastic composition.

2. Composition according to Claim 1, **characterized in that** the second polymer consists of a copolymer of ethylene and of an alkyl (meth)acrylate.

3. Composition according to Claim 1 or 2, **characterized in that** the number-average molar mass of the abovementioned polyamide grafts of the abovementioned grafted polymer is within the range from 1000 to 10 000 g/mol.

4. Composition according to any one of the preceding claims, **characterized in that**, for the abovementioned grafted polymers, the number of monomer (X) attached to the polyolefin trunk is greater than or equal to 1.3 and/or less than or equal to 20.

5. Composition according to any one of the preceding claims, **characterized in that** the abovementioned first polymer is present in the composition at between 10% and 50% by weight.

6. Composition according to any one of the preceding claims, **characterized in that** the polyamide grafts of the first polymer consist of copolyamides chosen from the copolyamides PA 6/11, PA6/12 and PA6/11/12.

7. Composition according to any one of the preceding claims, **characterized in that** the third polymer consists of an ethylene-acrylic ester-glycidyl methacrylate or ethylene-acrylic ester-maleic anhydride copolymer.

8. Composition according to any one of the preceding claims, **characterized in that** the unsaturated monomer (X) of the first polymer is a maleic anhydride.

9. Composition according to any one of the preceding claims, **characterized in that** the second polymer is present in the composition at between in the composition at between 40% and 70% by weight.

10. Composition according to Claim 8, **characterized in that** the third polymer is present at between 10% and 30% by weight in the composition.

11. Composition according to any one of the preceding claims, **characterized in that** it consists solely of the three abovementioned polymers.

12. Thermoplastic film comprising the composition according to any one of the preceding claims.

13. Thermoplastic film of a photovoltaic module, said photovoltaic module comprising at least two layers, one of which forms the encapsulant layer and/or a protective back layer, **characterized in that** the encapsulant layer comprises, and preferably consists of, the thermoplastic composition according to any one of Claims 1 to 11.

14. Film according to Claim 13, **characterized in that** the layer forming the encapsulant comprises adhesion promoters consisting of a non-polymeric ingredient, of organic, crystalline or mineral and more preferentially semi-mineral semi-organic nature, antioxidants and/or UV stabilizers.
